# EUROPEAN PATENT SPECIFICATION

(11) **EP 3 910 919 B1**
(45) Date of publication and mention of the grant of the patent: **30.08.2023**
(21) Application number: 20763486.6
(22) Date of filing: 21.01.2020
(51) Int. Cl.: H04M 1/02, F16C 11/04, G06F 1/16, G09F 9/30

(54) **ROTATING DEVICE, HOUSING, AND ELECTRONIC DEVICE**
DREHVORRICHTUNG, GEHÄUSE UND ELEKTRONISCHE VORRICHTUNG
DISPOSITIF ROTATIF, BOÎTIER ET DISPOSITIF ÉLECTRONIQUE

(30) Priority: 25.02.2019 CN 201910139447
(43) Date of publication of application: 17.11.2021
(73) Proprietor: GUANGDONG OPPO MOBILE TELECOMMUNICATIONS CORP., LTD., Dongguan, Guangdong 523860 (CN)
(72) Inventor: CHENG, Jiao, Dongguan, Guangdong 523860 (CN); ZUO, Zhouquan, Dongguan, Guangdong 523860 (CN)
(74) Representative: Thorniley, Peter
(86) International application number: PCT/CN2020/073616
(87) International publication number: WO 2020/173269

(56) References cited:
- WO-A1-2006/013884
- CN-A- 105 549 690
- CN-A- 108 200 248
- CN-A- 108 632 411
- CN-A- 109 256 048
- CN-U- 205 750 631
- CN-U- 207 777 905
- CN-U- 208 073 970
- US-A1- 2014 360 296

## Description

### TECHNICAL FIELD

The present disclosure relates to foldable screens, and more particularly, to a rotating device for a foldable screen, a housing having the rotating device, and an electronic device with the housing.

### BACKGROUND

Flexible display screens are widely favored by consumers due to their advantages of foldability, curved surfaces, flexibility, and stretchability. Generally, conventional flexible display screens are supported on a housing of an electronic device via hinges, which can allow the flexible display screens to be supported and folded. However, the existing hinges generally include several links, several rotation shafts, and a damping mechanism Therefore, the existing hinges have a complicated structure and high manufacturing cost. CN105549690A discloses a folding mobile terminal. US2014360296A1 discloses a biaxial pivot mechanism and a portable electronic device thereof. CN207777905U discloses an infolding flexible screen mobile terminal and a hinge of the infolding flexible screen mobile terminal. CN109256048A discloses a folding mechanism for flexible screen.

### SUMMARY

An object of the present disclosure is to provide a rotating device having a simple structure, a housing provided with the rotating device, and an electronic device provided with the housing.

To solve the above technical problems, the present disclosure provides a rotating device. The rotating device includes at least one pair of rotation combinations, and a gear combination located between the at least one pair of rotation combinations. Each rotation combination of the at least one pair of rotation combinations includes a support frame, a rotating rack rotatably connected to the support frame, and a connecting rod arranged between the support frame and the rotating rack. One end of the connecting rod is movably connected to the rotating rack. The other end of the connecting rod is provided with a driving gear configured to engage with the gear combination and is rotatably connected to the support frame. The rotating racks of one pair of rotation combinations are synchronously rotatable by rotating at least one rotating rack of the rotating racks relative to at least one corresponding support frame to rotate at least one corresponding connecting rod, and rotating, by the rotation of the at least one corresponding connecting rod, at least one corresponding driving gear of the at least one corresponding connecting rod, and further driving, by the rotation of the at least one corresponding driving gear, the gear combination to rotate. The rotating rack includes a mounting frame. The rotating rack further includes a rotating block arranged on the mounting frame, the rotating block and the connecting rod are located on a same side of the mounting frame, an accommodating opening is defined in the support frame, and the rotating block is rotatably connected in the accommodating opening.

The present disclosure also provides a housing. The housing includes a first frame body, a second frame body, and a rotating device. The rotating device is connected between the first frame body and the second frame body. The rotating device is configured to fold or unfold the first frame body and the second frame body. The rotating device includes at least one pair of rotation combinations, and a gear combination located between the at least one pair of rotation combinations. Each rotation combination of the at least one pair of rotation combinations includes a support frame, a rotating rack rotatably connected to the support frame, and a connecting rod arranged between the support frame and the rotating rack. One end of the connecting rod is movably connected to the rotating rack. The other end of the connecting rod is provided with a driving gear configured to engage with the gear combination and is rotatably connected to the support frame. The rotating racks of one pair of rotation combinations are synchronously rotatable by rotating at least one rotating rack of the rotating racks relative to at least one corresponding support frame to rotate at least one corresponding connecting rod, and rotating, by the rotation of the at least one corresponding connecting rod, at least one corresponding driving gear of the at least one corresponding connecting rod, and further driving, by the rotation of the at least one corresponding driving gear, the gear combination to rotate. The rotating rack includes a mounting frame. The rotating rack further includes a rotating block arranged on the mounting frame, the rotating block and the connecting rod are located on a same side of the mounting frame, an accommodating opening is defined in the support frame, and the rotating block is rotatably connected in the accommodating opening. In this way, the rotating device can fold or unfold the first frame body and the second frame body.

The present disclosure further provides an electronic device. The electronic device includes a flexible screen and a housing. The flexible screen is arranged on the housing. The housing includes a first frame body, a second frame body, and a rotating device. The rotating device is connected between the first frame body and the second frame body. The rotating device includes at least one pair of rotation combinations, and a gear combination located between the at least one pair of rotation combinations. Each rotation combination of the at least one pair of rotation combinations includes a support frame, a rotating rack rotatably connected to the support frame, and a connecting rod arranged between the support frame and the rotating rack. One end of the connecting rod is movably connected to the rotating rack. The other end of the connecting rod is provided with a driving gear configured to engage with the gear combination and is rotatably connected to the support frame. The rotating racks of one pair of rotation combinations are synchronously rotatable by rotating at least one rotating rack of the rotating racks relative to at least one corresponding support frame to rotate at least one corresponding connecting rod, and rotating, by the rotation of the at least one corresponding connecting rod, at least one corresponding driving gear of the at least one corresponding connecting rod, and further driving, by the rotation of the at least one corresponding driving gear, the gear combination to rotate. The rotating rack includes a mounting frame. The rotating rack further includes a rotating block arranged on the mounting frame, the rotating block and the connecting rod are located on a same side of the mounting frame, an accommodating opening is defined in the support frame, and the rotating block is rotatably connected in the accommodating opening. In this way, the rotating device can fold or unfold the first frame body and the second frame body.

In the present disclosure, the rotating device of the electronic device includes one pair of rotation combinations and a gear combination located between the one pair of rotation combinations, a rotating rack of each rotation combination is rotatably connected to a support frame, and a connecting rod of each rotation combination is arranged between the support frame and the rotating rack; one end of the connecting rod is movably connected to the rotating rack, and the other end of the connecting rod is provided with a driving gear engaging with the gear combination and is rotatably connected to the support frame. The rotating racks of one pair of rotation combinations can be synchronously rotated by rotating at least one rotating rack of the rotating racks relative to the corresponding support frame to rotate the corresponding connecting rod, and further rotating the gear combinations by the driving gear of the corresponding connecting rod. In this way, the first frame body and the second frame body can be synchronously rotated towards or away from each other through linkage of the rotating device, thereby folding or unfolding the first frame body and the second frame body. The rotating device can realize synchronous linkage rotation, facilitate folding or unfolding of the electronic device, and is convenient to use. In addition, the rotating device has a simple structure, which can be assembled and disassembled conveniently, thereby saving the time for assembly and disassembly and reducing the production costs.

### BRIEF DESCRIPTION OF DRAWINGS

In order to clearly explain technical solutions of embodiments of the present disclosure, drawings used in embodiments are briefly described below. The drawings as described below are merely some embodiments of the present disclosure. Based on these drawings, other obvious variants can be obtained by those skilled in the art without creative effort.
FIG. 1 is a schematic perspective view of an electronic device according to an embodiment of the present disclosure.
FIG. 2 is an exploded perspective view of an electronic device in FIG. 1.
FIG. 3 is an exploded perspective view of a main rotating body and a shell of a rotating device in FIG. 2.
FIG. 4 is an exploded perspective view of a main rotating body of a rotating device in FIG. 3, where the main rotating body includes one pair of rotation combinations and a gear combination.
FIG. 5 is an exploded perspective view of one rotation combination in FIG. 4.
FIG. 6 is an exploded perspective view of the other rotation combination in FIG. 4.
FIG. 7 is a schematic diagram of a partially assembled electronic device in FIG. 2.
FIG. 8 is a schematic diagram of an electronic device in FIG. 7, which is further assembled.
FIG. 9 is a cross-sectional view taken along line IX-IX in FIG. 1.
FIG. 10 is a schematic diagram illustrating a folded state of an electronic device in FIG. 1.
FIG. 11 is an exploded view of an electronic device in FIG. 10.
FIG. 12 is a cross-sectional view taken along line XII-XII in FIG. 10.
FIG. 13 is a schematic diagram illustrating an unfolding process of an electronic device according to an embodiment of the present disclosure.

### DESCRIPTION OF EMBODIMENTS

A rotating device is provided. The rotating device includes a pair of rotation combinations and a gear combination located between the at least one pair of rotation combinations. Each rotation combination of the at least one pair of rotation combinations includes a support frame, a rotating rack rotatably connected to the support frame, and a connecting rod arranged between the support frame and the rotating rack. One end of the connecting rod is movably connected to the rotating rack. The other end of the connecting rod is provided with a driving gear configured to engage with the gear combination and is rotatably connected to the support frame. The rotating racks of one pair of rotation combinations can be synchronously rotated by rotating at least one rotating rack of the rotating racks relative to the support frame corresponding to the at least one rotating rack to rotate the connecting rod corresponding to the at least one rotating rack, and further rotating the gear combinations by the driving gear of the corresponding connecting rod.

An end of the connecting rod facing away from the driving gear can be connected to the rotating rack through a fitting connection between a connecting shaft and a connecting rod slot. The connecting shaft can be slidably and rotatably connected in the connecting rod slot.

The connecting rod slot can be an inclined slot. The connecting rod slot can be defined in the rotating rack. The connecting shaft can be arranged on the connecting rod.

The rotating rack includes a mounting frame. Two extension plates oppositely spaced apart from each other are provided on the mounting frame. Each of the two extension plates can have the connecting rod slot defined therein to form one pair of connecting rod slots, and the connecting shaft can be fixed on the end of the connecting rod facing away from the driving gear. The end of the connecting rod on which the connecting shaft is fixed can be located between the two extension plates. Two opposite ends of the connecting shaft can be movably inserted into the one pair of connecting rod slots, correspondingly.

The rotating rack further includes a rotating block arranged on the mounting frame. The rotating block and the connecting rod are located on a same side of the mounting frame. An accommodating opening is defined in the support frame. The rotating block is rotatably connected in the accommodating opening.

A rotation shaft between the rotating block and the support frame can be a virtual shaft.

The rotating block and the support frame can be connected to each other through a rotating rib and an arc-shaped groove. The rotating rib can be slidably accommodated in the arc-shaped groove. An axis of the arc-shaped groove can coincide with an axis of the rotation shaft between the rotating block and the support frame.

Each of two opposite side surfaces of the rotating block can have the arc-shaped groove defined therein to form one pair of arc-shaped grooves. Each of two opposite inner walls of the accommodating opening of the support frame can have the rotating rib provided thereon to form one pair of rotating ribs in correspondence to the one pair of arc-shaped grooves.

Each of two opposite inner walls of the accommodating opening of the support frame can have the arc-shaped groove defined therein to form one pair of arc-shaped grooves, and each of two opposite side surfaces of the rotating block can have the rotating rib provided thereon to form one pair of rotating ribs in correspondence to the one pair of arc-shaped grooves.

The rotating rack can further include a connecting plate connected between the rotating block and the mounting frame. The support frame can include a positioning rod arranged in the accommodating opening and on one side of the accommodating opening. The positioning rod can be configured to support a rear surface of the connecting plate.

A reinforcing plate can be provided on the connecting plate to reinforce a connection between the rotating block and the mounting frame.

The gear combination can include at least one pair of transmission gears engaging with each other. One pair of transmission gears of at least one pair of transmission gears can be rotatably arranged between two support frames. The one pair of transmission gears can engage with the driving gears of the connecting rods of one pair of rotation combinations, correspondingly.

The rotating device can further include a housing. One pair of connecting blocks can be provided on an inner surface of the housing. A connection opening can be defined in a rear surface of each support frame of one pair of support frames. The one pair of connecting blocks is connected to the connection openings of the one pair of support frames, respectively.

A connecting hole can be defined in each connecting block of the one pair of connecting blocks. One pair of rotation combinations can be fixed in the housing by a locking member penetrating the support frame and being locked in a corresponding connecting hole.

A housing is provided. The housing can include a first frame body, a second frame body, and the rotating device. The rotating device can be connected between the first frame body and the second frame body. The rotating device can be configured to fold or unfold the first frame body and the second frame body.

A first accommodating groove can be defined on a side of the first frame body adjacent to the second frame body. A second accommodating groove can be defined on a side of the second frame body adjacent to the first frame body. The first accommodating groove and the second accommodating groove can define an accommodating space. The rotating device can be accommodated in the accommodating space.

A first mounting groove can be defined in the first frame body. A second mounting groove can be defined in the second frame body. The rotating racks of one pair of rotation combinations of the rotating device can be connected into the first mounting groove of the first frame body and the second mounting groove of the second frame body, respectively.

The housing further can include two cover plates respectively covering the first frame body and the second frame body. In an unfolded state of the first frame body and the second frame body, front surfaces of the two cover plates can be on a same plane.

An electronic device is provided. The electronic device can include a flexible screen and the housing. The flexible screen can be arranged on the housing.

A rotation shaft of each of one pair of rotation combinations of the rotating device can be a virtual shaft. An axis of the virtual shaft can be located on a neutral layer of the flexible screen.

The technical solutions according to the embodiments of the present disclosure will be clearly and completely described below in combination with the accompanying drawings of the embodiments of the present disclosure. The embodiments described below are only a part of the embodiments of the present disclosure, rather than all of the embodiments.

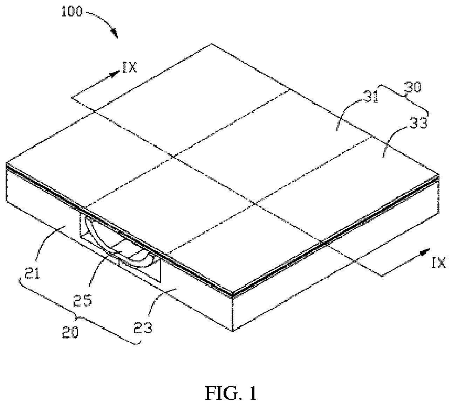

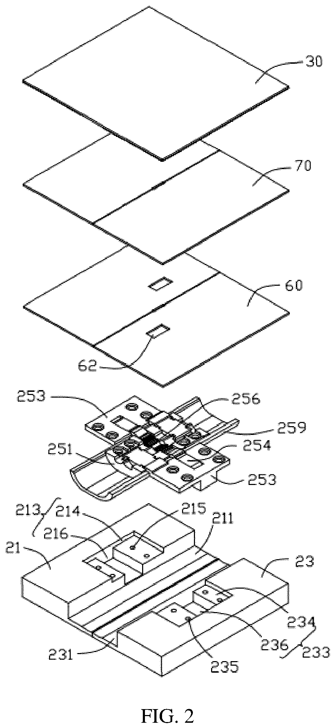

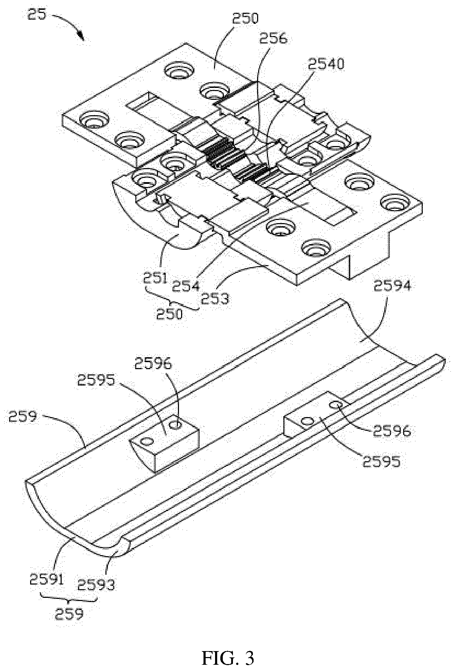

FIG. 1 is a schematic perspective view of an electronic device according to an embodiment of the present disclosure. FIG. 2 is an exploded perspective view of an electronic device in FIG. 1. FIG. 3 is an exploded perspective view of a main rotating body and a shell of a rotating device in FIG. 2. Referring to FIG. 1 to FIG. 3, an electronic device 100 according to an embodiment of the present disclosure includes a housing 20 and a flexible screen 30 disposed on a front surface of the housing 20. The housing 20 includes a first frame body 21, a second frame body 23, and a rotating device 25 connected between the first frame body 21 and the second frame body 23. The flexible screen 30 is disposed on the first frame body 21, the second frame body 23, and the rotating device 25. The flexible screen 30 has a foldable region 31 corresponding to the rotating device 25, and two non-foldable regions 33 connected to two opposite sides of the foldable region 31. The rotating device 25 is supported on a rear surface of the foldable region 31 of the flexible screen 30. The rotating device 25 is configured to fold or unfold the first frame body 21 and the second frame body 23. The rotating device 25 includes a main rotating body and a shell 259. The main rotating body includes at least one pair of rotation combinations 250 and a gear combination 256 located between the at least one pair of rotation combinations 250. Each rotation combination 250 includes a support frame 251, a rotating rack 253 rotatably connected to the support frame 251, and a connecting rod 254 arranged between the support frame 251 and the rotating rack 253. One end of the connecting rod 254 is movably connected to the rotating rack 253. A driving gear 2540 is provided at the other end of the connecting rod 254 and configured to engaged with the gear combination 256. The other end of the connecting rod 254 provided with the driving gear 2540 is rotatably connected to the support frame 251. The support frames 251 of the one pair of rotation combinations 250 are fixed in the shell 259. Ends of the rotating racks 253 of the one pair of rotation combinations 250 facing away from the support frames 251 are fixed to the first frame body 21 and the second frame body 23, respectively. At least one rotating rack 253 is rotatable relative to a corresponding support frame 251 to drive a corresponding connecting rod 254 to rotate and further to drive the driving gear 2540 of the corresponding connecting rod 254 to rotate. The driving gear 2540 is configured to drive the gear combination 256 to rotate, so as to allow the rotating racks 253 of the one pair of rotation combinations 250 to rotate synchronically. In this way, the first frame body 21 and the second frame body 23 can synchronously rotate towards each other or away from each other. That is, the first frame body 21 and the second frame body 23 are folded or unfolded through a linkage of the rotating device 25.

In an embodiment, the electronic device 100 is a mobile phone. It can be understood that, in other embodiments, the electronic device 100 may be, but not limited to, a radio phone, a pager, a Web browser, a notebook, a calendar, and/or a Personal Digital Assistant (PDA) of a Global Positioning System (GPS) receiver.

The rotating device 25 of the electronic device 100 of the present disclosure includes one pair of rotation combinations 250, and a gear combination 256 located between the one pair of rotation combinations 250. The rotating rack 253 of each rotation combination 250 is rotatably connected to the support frame 251. The connecting rod 254 of each rotation combination 250 is arranged between the support frame 251 and the rotating rack 253. One end of the connecting rod 254 is movably connected to the rotating rack 253. The other end of the connecting rod 254 is provided with the driving gear 2540 to engage with the gear combination 256. The other end of the connecting rod 254 provided with the driving gear 2540 is rotatably connected to the support frame. When at least one rotating rack 253 rotates relative to a corresponding support frame 251, the at least one rotating rack 253 can drive the corresponding connecting rod 254 to rotate and can further drive the driving gear 2540 on the connecting rod 254 to rotate. The driving gear 2540 can drive the gear combination 256 to rotate, so as to allow the rotating racks 253 of the one pair of rotation combinations 250 to rotate synchronically. Therefore, the first frame body 21 and the second frame body 23 can synchronously rotate towards each other or away from each other through the linkage of the rotating device 25 between the first frame body 21 and the second frame body 23, thereby folding or unfolding the first frame body 21 and the second frame body 23. The synchronous linkage rotation achieved by the rotating device 25 facilitates the folding or unfolding of the electronic device 100, which is convenient to use. In addition, the rotating device 25 has a simple structure and can be assembled and disassembled conveniently, such that the time for assembly and disassembly can be saved, and production costs can be reduced.

A rotation shaft between the rotating rack 253 and the support frame 251 of each rotation combination 250 of the rotating device 25 may be a virtual shaft. An axis of the virtual shaft may be located outside the rotation combination 250. Specifically, the axis of the rotation shaft of each rotation combination 250 of the rotation device 25 is located on a neutral layer of the flexible screen 30 of the electronic device 100, such that a folding resistance of the flexible screen 30 can be improved and the flexible screen 30 is prevented from being damaged to the greatest extent.

During a folding process of the flexible screen 30, an outer layer of the flexible screen 30 is stretched, and an inner layer of the flexible screen 30 is squeezed. In a cross section of the flexible screen 30, the neutral layer is a transition layer of the flexible screen 30 that is neither stretched nor squeezed in a cross section of the flexible screen 30 and subjected to an insignificant stress. The axis of the rotation shaft of the rotation combination 250 of the rotation device 25 according to the present disclosure is always located on the neutral layer no matter when the electronic device 100 is folded or unfolded, thereby preventing the flexible screen 30 from being damaged to the greatest extent. In the present disclosure, the front surface refers to a surface facing towards a light-emitting surface of the flexible screen 30, and the rear surface refers to a surface facing away from the light-emitting surface of the flexible screen 30.

As illustrated in FIG. 2, a first accommodating groove 211 is defined on a side of the first frame body 21 close to the second frame body 23, and a second accommodating groove 231 is defined on a side of the second frame body 23 close to the first frame body 21. When the first frame body 21 and the second frame body 23 of the electronic device 100 are in an unfolded state, the first accommodating groove 211 and the second accommodating groove 231 define an accommodating space. The rotating device 25 is accommodated in the accommodating space. A first connecting space 213 having a T-shaped cross section is defined in a front surface of the first frame body 21 adjacent to the first accommodating groove 211. The first connecting space 213 communicates with the first accommodating groove 211. The first connecting space 213 includes a rectangular accommodating groove 214 and a positioning groove 216 defined in a bottom surface of the accommodating groove 214 of the first frame body 21. The first connecting space 213 is configured to mount one rotating rack 253. A plurality of locking holes 215 is defined on the bottom surface of the accommodating groove 214. A second connecting space 233 is defined on a front surface of the second frame body 23 adjacent to the second accommodating groove 231. The second connecting space 233 communicates with the second accommodating groove 231. The second connecting space 233 includes a rectangular accommodating groove 234 and a positioning groove 236 defined in a bottom surface of the accommodating groove 234 of the second frame body 23. The second connecting space 233 is configured to mount another rotating rack 253. Specifically, a plurality of locking holes 235 is defined on a bottom surface of the second connecting space 233.

As illustrated in FIG. 3, the shell 259 includes a rectangular base plate 2591 and two arc-shaped side plates 2593 located on two opposite side edges of the base plate 2591. The base plate 2591 and the two side plates 2593 jointly define a mounting space 2594. The support frames 251 of the one pair of rotation combinations 250 and the gear combination 256 are accommodated in the mounting space 2594. A connecting block 2595 is provided on an inner surface of each of the two side plates 2593 by protruding towards the mounting space 2594. A connecting hole 2596 is defined in the connecting block 2595.

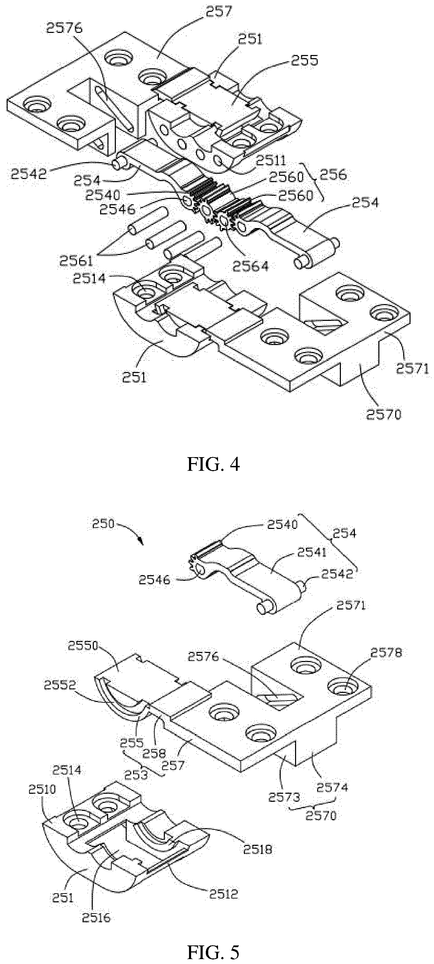

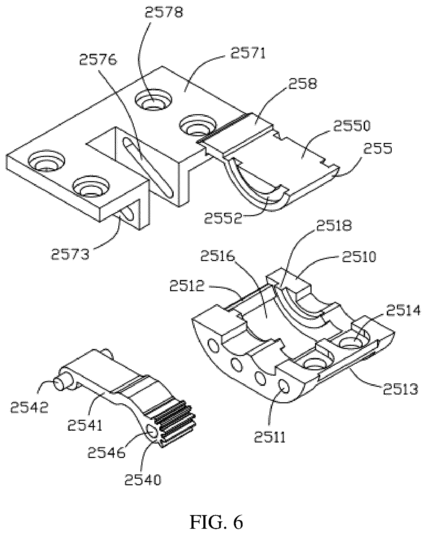

FIG. 4 is an exploded perspective view of a main rotating body of a rotating device in FIG. 3. FIG. 5 is an exploded perspective view of one rotation combination in FIG. 4. FIG. 6 is an exploded perspective view of the other rotation combination in FIG. 4. Referring to FIG. 4 to FIG. 6, the support frame 251 includes a front surface 2510 and a rear surface. The rear surface can be attached to an inner surface of the shell 259. A plurality of shaft holes 2511 is defined on an end surface of the support frame 251. The plurality of shaft holes 2511 is configured to connect the gear combination 256. In an embodiment, each support frame 251 is provided with four shaft holes 2511 that are spaced apart from each other on an end surface facing towards another support frame 251. A connection opening 2513 is defined on the rear surface in correspondence to the connecting block 2595 on the shell 259. The connecting block 2595 can be accommodated in the connection opening 2513. A through hole 2514 corresponding to the connecting hole 2596 is defined on the front surface of the support frame 251. The through hole 2514 is a countersunk hole for receiving a head of the locking member. An accommodating opening 2516 is defined in a middle portion of the front surface 2510 of the support frame 251. The accommodating opening 2516 is away from the connection opening 2513. The accommodating opening 2516 penetrates through the rear surface of the support frame 251. The support frame 251 includes a positioning rod 2512 arranged on one side of the accommodating opening 2516 facing away from the through hole 2514. Two opposite ends of the positioning rod 2512 are connected to two opposite inner walls of the accommodating opening 2516, respectively. In addition, the positioning rod 2512 is close to the front surface 2510 of the support frame 251. That is, a front surface of the positioning rod 2512 is spaced apart from the front surface 2510 of the support frame 251. The support frame 251 includes one pair of arc-shaped rotating ribs 2518 protruding from two opposite inner walls of the accommodating opening 2516 towards the accommodating opening 2516. An axis of the rotating rib 2518 coincides with the axis of the rotation shaft between the rotating rack 253 and the support frame 251 of the rotation combination 250. Two ends of the rotating rib 2518 extend to the front surface 2510 of the support frame 251.

The rotating rack 253 includes a rotating block 255, a mounting frame 257, and a connecting plate 258 connected between the rotating block 255 and the mounting frame 257. A reinforcing plate is added to the connecting plate 258 to reinforce a connection between the rotating block 255 and the mounting frame 257. The rotating block 255 is a semi-cylindrical rotating block. That is, a cross section of the rotating block 255 is arc-shaped. The rotating block 255 has a rectangular front surface 2550 and an arc-shaped rear surface. The rotating block 255 can be rotatably accommodated in the accommodating opening 2516 of the support frame 251. A pair of arc-shaped grooves 2552 are defined on two opposite lateral surfaces of the rotating block 255. The one pair of arc-shaped grooves 2552 corresponds to the one pair of rotating ribs 2518 in the accommodating opening 2516 of the support frame 251 in one-to-one correspondence. An axis of the arc-shaped groove 2552 coincides with the axis of the rotation shaft between the rotating rack 253 and the support frame 251 of the rotation combination 250. Two ends of the arc-shaped groove 2552 penetrate through the front surface 2550 of the rotating block 255. The mounting frame 257 includes a rectangular connecting plate 2571, and a positioning portion 2570 protruding from a rear surface of the connecting plate 2571. The positioning portion 2570 includes two extension plates 2573 that are arranged on the rear surface of the connecting plate 2571 and spaced apart from each other, and an end plate 2574 connected between respective ends of the two extension plates 2573 facing away from the rotating block 255. The two extension plates 2573 and the end plate 2574 together define an accommodating space configured to accommodate an end of the connecting rod 254. The extension plates 2573 extends in a direction perpendicular to the axis of the arc-shaped grooves 2552. A connecting rod slot 2576 is defined in each of the two extension plates 2573 as one pair of connecting rod slots 2576. Each connecting rod slot 2576 extends obliquely. Specifically, each connecting rod slot 2576 obliquely extends on a corresponding extension plate 2573 from a position close to the end plate 2574 and close to the connecting plate 2571 along an extending direction of the corresponding extension plate 2573. The rotating block 255 is located at an end of the connecting plate 2571 facing away from the end plate 2574. That is, the rotating block 255 is connected to an end portion of the connecting plate 2571 on a side facing away from the end plate 2574 through the connecting plate 258. A plurality of mounting holes 2578 is defined on a front surface of the connecting plate 2571 on two lateral sides of the positioning portion 2570. Each plurality of mounting hole 2578 is a countersunk through hole.

The connecting rod 254 includes a connecting rod strip 2541, a connecting shaft 2542 arranged at one end of the connecting rod strip 2541, and a driving gear 2540 arranged at the other end of the connecting rod strip 2541. The connecting rod strip 2541 includes a straight portion and an arc-shaped portion. The connecting shaft 2542 is fixed to an end of the straight portion facing away from the arc-shaped portion. The driving gear 2540 is arranged at an end of the arc-shaped portion facing away from the connecting shaft 2542. An axis of the connecting shaft 2542 is parallel to an axis of the driving gear 2540. A shaft hole 2546 is defined in a middle portion of the driving gear 2540 along an axial direction. The driving gear 2540 includes a gear body and a plurality of teeth. Each of the plurality of teeth protrudes from an outer peripheral surface of the gear body in a direction perpendicular to an axial direction of the connecting shaft 2542, and longitudinally extends in a direction parallel to the axial direction of the connecting shaft 2542. In an embodiment, the plurality of teeth of the driving gear 2540 is not distributed in a complete circumferential array on the outer peripheral surface of the gear body, and instead, the plurality of teeth of the driving gear 2540 forms an arcuate array on the outer peripheral surface of the gear body facing away from the connecting shaft 2542. For example, the driving gear 2540 includes five teeth. In other embodiments, the plurality of teeth of the driving gear 2540 may be arranged around the gear body.

In other embodiments, the connecting rod slot may be defined on the connecting rod 254. The connecting shaft may be arranged on the rotating rack 253. Specifically, an inclined connecting rod slot is defined at an end of the connecting rod 254 facing away from the driving gear 2540. A connecting shaft corresponding to the connecting rod slot protrudes from the rotating rack 253.

As illustrated in FIG. 4, the gear combination 256 includes one pair of transmission gears 2560 and a plurality of rotation shafts 2561. The one pair of transmission gears 2560 can engage with each other, and can respectively engage with the driving gears 2540 of the connecting rods 254 of the one pair of rotation combinations 250. A through hole 2564 is axially defined in a middle portion of each transmission gear 2560. One rotation shaft 2561 is fixed in the through hole 2564. The one rotation shaft 2561 is also fixed in a shaft hole 2546 of each driving gear 2540. In the present disclosure, the transmission gear 2560 and the driving gear 2540 are both a spur gear.

During the assembly of the rotating device 25, each rotation combination 250 is assembled first. Specifically, the rotating rack 253 is rotatably connected to the support frame 251. That is, the rotating block 255 of the rotating rack 253 is inserted into the accommodating opening 2516 of the support frame 251, the one pair of rotating ribs 2518 is slidably accommodated in the one pair of arc-shaped grooves 2552 of the rotating block 255, and thus the rotating rack 253 is rotatably connected to the support frame 251. The end of the connecting rod 254 provided with the connecting shaft 2542 is accommodated between the two extension plates 2573 to movably insert the opposite ends of the connecting shaft 2542 into the two connecting rod slots 2576, respectively. The gear combination 256 is mounted between the one pair of rotation combinations 250. Specifically, the gear combination 256 is placed between the one pair of rotation combinations 250 in such a manner that the rotation shafts 2561 on the paired transmission gears 2560 are aligned with two shaft holes 2511 in a middle portion of each rotation combination 250, and the two opposite ends of each rotation shaft 2561 are rotatably inserted into the corresponding shaft holes 2511. In addition, the rotation shafts 2561 on the driving gears 2540 of the two connecting rods 254 directly face towards two shaft holes 2511 on an outer side of each rotation combination 250, such that two opposite ends of each rotation shaft 2561 of each driving gear 2540 can be rotatably inserted into the corresponding shaft holes 2511. In this case, for one same rotation combination 250, the rotating block 255 and the driving gear 2540 of the connecting rod 254 are located on a same side of the rotating rack 253, and the paired transmission gears 2560 engage with each other and respectively engage with the one pair of driving gears 2540, thereby forming a linkage mechanism. The paired rotation combinations 250 are placed in the shell 259. The two connecting blocks 2595 are respectively inserted into the connecting openings 2513 of the paired rotation combinations 250, and a plurality of locking members is provided to penetrate the through holes 2514 of a corresponding support frame 251 and to be locked in the corresponding connecting hole 2596, so as to fix the paired rotation combinations 250 in the shell 259.

The support frame 251 and the rotating rack 253 of each assembled rotation combination 250 can rotate with respect to each other through a connection between the arc-shaped groove 2552 and the rotating rib 2518 that are mutually fitted to each other. The arc-shaped groove 2552 is defined on the rotating rack 253. The rotating rib 2518 is provide on the support frame 251. The rotation shaft between the rotating rack 253 and the support frame 251 is a virtual shaft. The axis of the virtual shaft is located outside each rotation combination 250. The axis of the virtual shaft coincides with the axis of the arc-shaped groove 2552.

In other embodiments, the arc-shaped groove may also be defined on the support frame 251, and the rotating rib may be provided on the rotating rack 253. Specifically, the arc-shaped groove is defined on an inner wall of the accommodating opening 2516 of the support frame 251, and the rotating rib is provided by protruding from the rotating block 255. The rotating rib is slidably accommodated in the arc-shaped groove, such that the rotating rack 253 and the support frame 251 are rotatably connected to each other.

As illustrated in FIG. 2, the electronic device 100 further includes two cover plates 60 respectively attached to front surfaces of the first frame body 21 and the second frame body 23, and a support sheet 70 attached to a rear surface of the flexible screen 30. A receiving groove 62 is defined on each cover plate 60. The receiving groove 62 corresponds to the reinforcing plate on the connecting plate 258 of the rotating rack 253. The support sheet 70 is a flexible support sheet. The support sheet 70 may be a thin metal sheet such as a copper foil, a liquid metal sheet, a memory alloy sheet, a plastic sheet; or a sheet made of other suitable materials. In an embodiment, the support sheet 70 is a thin steel sheet.

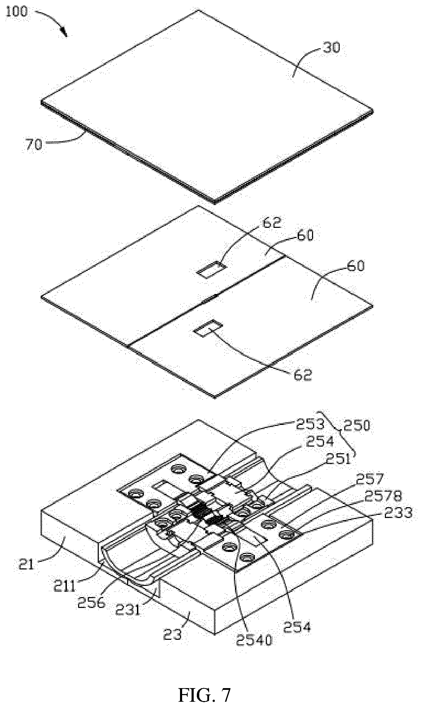

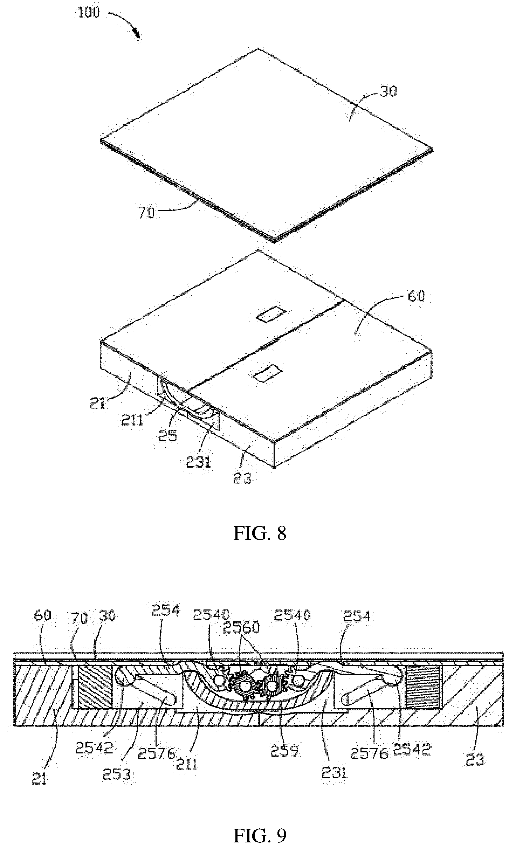

FIG. 7 is a schematic diagram of a partially assembled electronic device in FIG. 2. FIG. 8 is a schematic diagram of an electronic device in FIG. 7, which is further assembled. FIG. 9 is a cross-sectional view taken along line IX-IX in FIG. 1. Referring to FIG. 2, and FIG. 7 to FIG.9, during the assembly of the electronic device 100, the first frame body 21 and the second frame body 23 are flush with each other in such a manner that the first accommodating groove 211 of the first frame body 21 and the second accommodating groove 231 of the second frame body 23 define the accommodate space; the rotating device 25 is placed into the accommodating space, such that mounting frames 257 of the one pair of rotation combinations 250 are arranged in the second connecting space 233 of the first frame body 21 and the second connecting space 233 of the second frame body 23, respectively. Specifically, the positioning portion 2570 of one mounting frame 257 is snapped into the positioning groove 216, and the connecting plate 2571 is accommodated in the accommodating groove 214; the positioning portion 2570 of the other mounting frame 257 of the mounting frames 257 is snapped into the positioning groove 236, and the connecting plate 2571 is accommodated in the accommodating groove 234. A number of locking members respectively penetrates the mounting holes 2578 on the connecting plate 2571, and is locked in corresponding locking holes 215, 235. In this case, the first frame body 21 and the second frame body 23 are in an unfolded state, and each rotating rack 253 is positioned on a corresponding positioning rod 2512, i.e., the positioning rod 2512 is supported on a rear surface of the connecting plate 258 of the rotating rack 253. The two cover plates 60 are attached to the front surface of the first frame body 21 and the front surface of the second frame body 23, respectively. The reinforcing plate on the connecting plate 258 of each rotation combination 250 is accommodated in the receiving groove 62. Since a head of the locking member on the electronic device 100 is accommodated in a corresponding countersunk hole, allowing the front surfaces of the two cover plates 60 to be on a same plane, which is conducive to reducing an overall thickness of the electronic device 100. A front surface of the support sheet 70 is attached to the rear surface of the flexible screen 30, and the rear surface of the support sheet 70 is attached to the front surfaces of the two cover plates 60. In this way, the assembly of the electronic device 100 is completed.

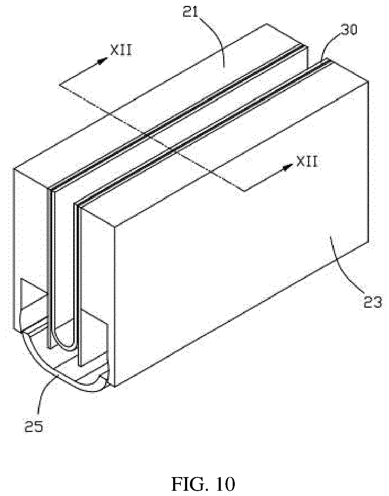

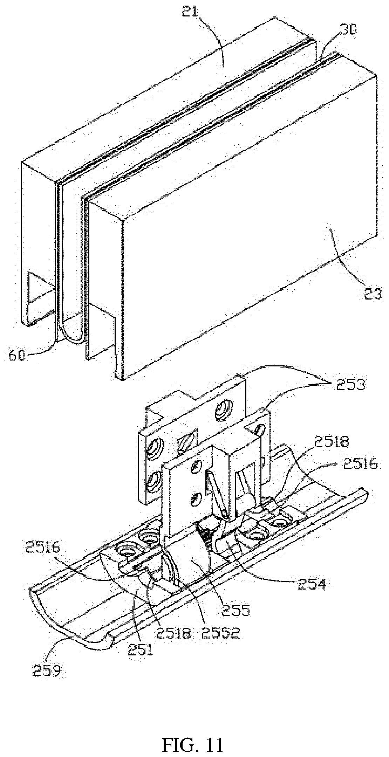

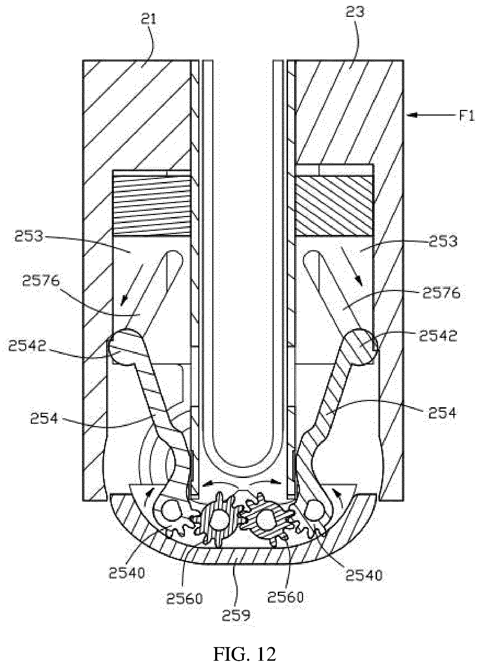

FIG. 10 is a schematic diagram illustrating a folded state of an electronic device in FIG. 1. FIG. 11 is an exploded view of an electronic device in FIG. 10. FIG. 12 is a cross-sectional view taken along line XII-XII in FIG. 10. Referring to FIG. 10 to FIG. 12, when the electronic device 100 needs to be folded, a folding force F1 is applied to at least one of the first frame body 21 and the second frame body 23 of the electronic device 100, for example, a folding force F1 applied to the second frame body 23 as illustrated in FIG. 12, such that the rotating racks 253 connected to the first frame body 21 and the second frame body 23 can rotate to approach to each other. Specifically, the rotating rack 253 fixed on the second frame body 23 rotates counterclockwise towards the first frame body 21, and the rotating block 255 rotates counterclockwise in the accommodating opening 2516 of the corresponding support frame 251. That is, the rotating rib 2518 slides in the corresponding arc-shaped groove 2552, such that the connecting shaft 2542 of the connecting rod 254 connected to the rotating rack 253 slides along the connecting rod slot 2576 towards an end close to the shell 259. In addition, the connecting shaft 2542 rotates in the connecting rod slot 2576, such that the driving gear 2540 of the connecting rod 254 rotates counterclockwise, the driving gear 2540 drives a corresponding transmission gear 2560 to rotate clockwise, the corresponding transmission gear 2560 drives the other corresponding transmission gear 2560 to rotate counterclockwise, and the other transmission gear 2560 drives the driving gear 2540 of the other connecting rod 254 to rotate clockwise. Consequently, the other connecting rod 254 rotates clockwise, the connecting shaft 2542 of the other connecting rod 254 slidably pushes against an inner wall of a corresponding connecting rod slot 2576, and the connecting shaft 2542 of the other connecting rod 254 rotates in the connecting rod slot 2576, such that the first frame body 21 rotates towards the second frame body 23. Therefore, the first frame body 21 and the second frame body 23 approach to each other. That is, the electronic device can be folded through the linkage of the rotating device 25.

During the folding of the electronic device 100, a folding force can also be applied to the first frame body 21, such that the rotating racks 253 connected to the first frame body 21 and the second frame body 23 can rotate to approach to each other. Specifically, the rotating rack 253 fixed on the first frame body 21 rotates clockwise in a direction of the second frame body 23, and the rotating block 255 rotates clockwise in the accommodating opening 2516 of the corresponding support frame 251. That is, the rotating rib 2518 slides in the corresponding arc-shaped groove 2552, and drives the rotating rack 253 to rotate clockwise, such that the connecting shaft 2542 of one connecting rod 254 connected to the rotating rack 253 slides along the connecting rod slot 2576 towards an end close to the shell 259. The connecting shaft 2542 rotates in the connecting rod slot 2576, such that the driving gear 2540 of the connecting rod 254 rotates clockwise, the driving gear 2540 drives the corresponding transmission gear 2560 to rotate counterclockwise, the corresponding transmission gear 2560 drives the other transmission gear 2560 to rotate clockwise, and the other transmission gear 2560 drives the driving gear 2540 of the other connecting rod 254 to rotate counterclockwise. In this way, the other connecting rod 254 rotates counterclockwise, and the connecting shaft 2542 of the other connecting rod 254 slidably pushes against an inner wall of the corresponding connecting rod slot 2576. In addition, the connecting shaft 2542 of the other connecting rod 254 rotates in the connecting rod slot 2576, such that the second frame body 23 is rotated towards the first frame body 21. Consequently, the first frame body 21 and the second frame body 23 approach to each other. That is, the electronic device can be folded through the linkage of the rotating device 25.

During the folding of the electronic device 100, a folding force can also be applied to each of the first frame body 21 and the second frame body 23, such that the rotating racks 253 connected to the first frame body 21 and the second frame body 23 can rotate to approach to each other. One of the rotating racks 253 rotates clockwise, and the other rotating rack 253 rotates counterclockwise. The driving gear 2540 of the connecting rod 254, which is located on the rotating rack 253 rotating clockwise, rotates clockwise. The driving gear 2540 of the connecting rod 254, which is located on the rotating rack 253 rotating counterclockwise, rotates counterclockwise. The connecting shaft 2542 on each connecting rod 254 slides towards the shell 259 in a corresponding connecting rod slot 2576, and rotates in the connecting rod slot 2576. The driving gear 2540 rotating clockwise drives a corresponding transmission gear 2560 to rotate counterclockwise. The driving gear 2540 rotating counterclockwise drives a corresponding transmission gear 2560 to rotate clockwise. In this way, the first frame body 21 and the second frame body 23 approach to each other, thereby folding the electronic device.

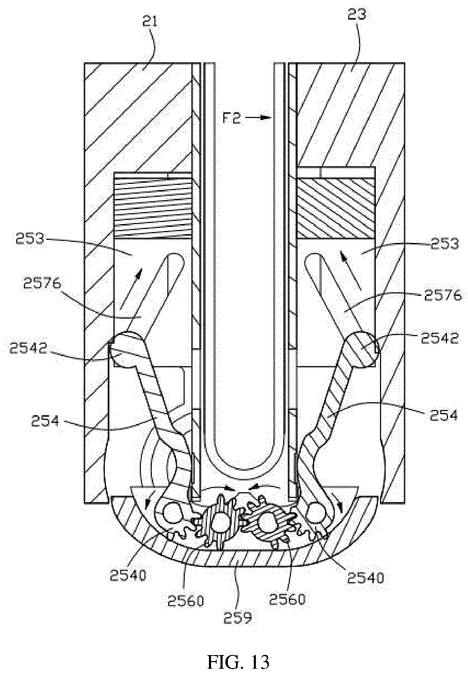

FIG. 13 is a schematic diagram illustrating an unfolding process of an electronic device according to an embodiment of the present disclosure. Referring to FIG. 13, when the electronic device 100 needs to be unfolded, an unfolding force F2 is applied to at least one of the first frame body 21 and the second frame body 23 of the electronic device 100, for example, an unfolding force F2 applied to the second frame body 23 as illustrated in FIG. 13, so as to rotate the rotating racks 253 connected to the first frame body 21 and the second frame body 23 in a direction facing away from each other. Specifically, the rotating block 255 fixed on the second frame body 23 rotates clockwise in the accommodating opening 2516 of a corresponding support frame 251. That is, the rotating rib 2518 slides in a corresponding arc-shaped groove 2552, and drives the rotating rack 253 to rotate clockwise, such that the connecting shaft 2542 of the connecting rod 254 connected to the rotating rack 253 slides along the connecting rod slot 2576 towards an end facing away from the shell 259. In addition, the connecting shaft 2542 rotates in the connecting rod slot 2576, such that the driving gear 2540 of the connecting rod 254 rotates clockwise. The driving gear 2540 drives a corresponding transmission gear 2560 to rotate counterclockwise. The corresponding transmission gear 2560 drives the other transmission gear 2560 to rotate clockwise. The other transmission gear 2560 drives the driving gear 2540 of the other connecting rod 254 to rotate counterclockwise, so as to rotate the other connecting rod 254 counterclockwise. The connecting shaft 2542 of the other connecting rod 254 slidably pushes against an inner wall of a corresponding connecting rod slot 2576. The connecting shaft 2542 of the other connecting rod 254 rotates in the connecting rod slot 2576, such that the first frame body 21 is rotated in a direction facing away from the second frame body 23. Consequently, the first frame body 21 and the second frame body 23 are moved away from each other. That is, the electronic device can be unfolded through the linkage of the rotating device 25.

During the unfolding of the electronic device 100, the unfolding force can also be applied to the first frame body 21, such that the rotating racks 253 fixedly connected to the first frame body 21 and the second frame body 23 can rotate in the direction facing away from each other. Specifically, the rotating block 255 fixed on the first frame body 21 rotates counterclockwise in the accommodating opening 2516 of a corresponding support frame 251. That is, the rotating rib 2518 slides in a corresponding arc-shaped groove 2552, and drives the rotating rack 253 to rotate counterclockwise, such that the connecting shaft 2542 of the connecting rod 254 connected to the rotating rack 253 slides towards along the connecting rod slot 2576 the end facing away from the shell 259. In addition, the connecting shaft 2542 rotates in the connecting rod slot 2576, such that the driving gear 2540 of the connecting rod 254 rotates counterclockwise. The driving gear 2540 drives a corresponding transmission gear 2560 to rotate clockwise. The corresponding transmission gear 2560 drives the other transmission gear 2560 to rotate counterclockwise. The other transmission gear 2560 drives the driving gear 2540 of the other connecting rod 254 to rotate clockwise. In this way, the other connecting rod 254 rotates clockwise, and the connecting shaft 2542 of the other connecting rod 254 slidably pushes against an inner wall of a corresponding connecting rod slot 2576. In addition, the connecting shaft 2542 of the other connecting rod 254 rotates in the connecting rod slot 2576, such that the second frame body 23 is rotated in a direction facing away from the first frame body 21, thereby moving the first frame body 21 and the second frame body 23 away from each other. That is, the electronic device can be unfolded through the linkage of the rotating device 25.

During the unfolding of the electronic device 100, the unfolding force can also be applied to each of the first frame body 21 and the second frame body 23, such that the rotating racks 253 connected to the first frame body 21 and the second frame body 23 can rotate in the direction facing away from each other. One of the rotating racks 253 rotates clockwise, and the other rotating rack 253 rotates counterclockwise. The driving gear 2540 of the connecting rod 254, which is located on the rotating rack 253 rotating clockwise, rotates clockwise. The driving gear 2540 of the connecting rod 254, which is located on the rotating rack 253 rotating counterclockwise, rotates counterclockwise. The connecting shaft 2542 on each connecting rod 254 slides in a corresponding connecting rod slot 2576 towards the end facing away from the shell 259, and rotates in the connecting rod slot 2576. The driving gear 2540 rotating clockwise drives a corresponding transmission gear 2560 to rotate counterclockwise. The driving gear 2540 rotating counterclockwise drives a corresponding transmission gear 2560 to rotate clockwise, thereby moving the first frame body 21 and the second frame body 23 away from each other. In this way, the unfolding of the electronic device in completed.

Due to a frictional damping force present between each driving gear 2540 and a corresponding transmission gear 2560 and between the two transmission gears 2560, the rotating device 25 can be positioned in any one of possible folding states between an unfolding state and a fully folded state in absence of an external force.

The present disclosure adopts engagement and linkage of spur gears, which does not require extremely high manufacturing accuracy and can reduce the cost effectively and improve the production efficiency, when compared with the situation using engagement and linkage of helical gears.

## Claims

1. A rotating device (25), comprising:
a pair of rotation combinations (250); and
a gear combination (256) located between the pair of rotation combinations (250),
wherein each rotation combination (250) of the pair of rotation combinations (250) comprises a support frame (251), a rotating rack (253) rotatably connected to the support frame (251), and a connecting rod (254) arranged between the support frame (251) and the rotating rack (253); one end of the connecting rod (254) is movably connected to the rotating rack (253), and the other end of the connecting rod (254) is provided with a driving gear (2540) configured to engage with the gear combination (256) and is rotatably connected to the support frame (251);
wherein the rotating rack (253) is configured to rotate relative to a corresponding support frame (251) and drive a corresponding connecting rod (254) to rotate; the connecting rod (254) is configured to rotate and drive the driving gear (2540) to rotate; the driving gear (2540) is configured to rotate and drive the gear combination (256) to rotate; and the rotating racks (253) of the pair of rotation combinations (250) are synchronously rotatable;
wherein the rotating rack (253) comprises a mounting frame (257),
**characterized in that**,
the rotating rack (253) further comprises a rotating block (255) arranged on the mounting frame (257), the rotating block (255) and the connecting rod (254) are located on a same side of the mounting frame (257), an accommodating opening (2516) is defined in the support frame (251), and the rotating block (255) is rotatably connected in the accommodating opening (2516).

2. The rotating device (25) according to claim 1, wherein an end of the connecting rod (254) facing away from the driving gear (2540) is connected to the rotating rack (253) through a fitting connection between a connecting shaft (2542) and a connecting rod slot (2576), and the connecting shaft (2542) is slidably and rotatably connected in the connecting rod slot (2576).

3. The rotating device (25) according to claim 2, wherein the connecting rod slot (2576) is an inclined slot, the connecting rod slot (2576) is defined in the rotating rack (253), and the connecting shaft (2542) is arranged on the connecting rod (254).

4. The rotating device (25) according to claim 3, wherein two extension plates (2573) oppositely spaced apart from each other and provided on the mounting frame (257);
each of the two extension plates (2573) has the connecting rod slot (2576) defined therein to form a pair of connecting rod slots (2576), and the connecting shaft (2542) is fixed on the end of the connecting rod (254) facing away from the driving gear (2540); and
the end of the connecting rod (254) on which the connecting shaft (2542) is fixed is located between the two extension plates (2573), and two opposite ends of the connecting shaft (2542) are movably inserted into the pair of connecting rod slots (2576), correspondingly.

5. The rotating device (25) according to claim 1, wherein a rotation shaft between the rotating block (255) and the support frame (251) is a virtual shaft.

6. The rotating device (25) according to claim 1, wherein the rotating block (255) and the support frame (251) are connected to each other through a rotating rib (2518) and an arc-shaped groove (2552), the rotating rib (2518) is slidably accommodated in the arc-shaped groove (2552), and an axis of the arc-shaped groove (2552) coincides with an axis of the rotation shaft between the rotating block (255) and the support frame (251).

7. The rotating device (25) according to claim 6, wherein each of two opposite side surfaces of the rotating block (255) has the arc-shaped groove (2552) defined therein to form a pair of arc-shaped grooves (2552), and each of two opposite inner walls of the accommodating opening (2516) of the support frame (251) has the rotating rib (2518) provided thereon to form a pair of rotating ribs (2518) in correspondence to the pair of arc-shaped grooves (2552); or
wherein each of two opposite inner walls of the accommodating opening (2516) of the support frame (251) has the arc-shaped groove (2552) defined therein to form a pair of arc-shaped grooves (2552), and each of two opposite side surfaces of the rotating block (255) has the rotating rib (2518) provided thereon to form a pair of rotating ribs (2518) in correspondence to the pair of arc-shaped grooves (2552).

8. The rotating device (25) according to claim 1, wherein the rotating rack (253) further comprises a connecting plate (258) connected between the rotating block (255) and the mounting frame (257), the support frame (251) comprises a positioning rod (2512) arranged in the accommodating opening (2516) and on one side of the accommodating opening (2516), and the positioning rod (2512) is configured to support a rear surface of the connecting plate (258); and
wherein a reinforcing plate is provided on the connecting plate (258) to reinforce a connection between the rotating block (255) and the mounting frame (257).

9. The rotating device (25) according to claim 1, wherein the gear combination (256) comprises a pair of transmission gears (2560) engaging with each other,
the pair of transmission gears (2560) is rotatably arranged between two support frames (251), and the pair of transmission gears (2560) engages with the driving gears (2540) of the connecting rods (254) of the pair of rotation combinations (250), correspondingly.

10. The rotating device (25) according to claim 1, further comprising a housing (20),
wherein a pair of connecting blocks (2595) is provided on an inner surface of the housing (20), a connection opening (2513) is defined on a rear surface of each support frame (251) of a pair of support frames (251), and the pair of connecting blocks (2595) is connected to the connection openings (2513) of the pair of support frames (251), respectively; and
wherein a connecting hole (2596) is defined in each connecting block (2595) of the pair of connecting blocks (2595), and the pair of rotation combinations (250) is fixed in the housing (20) by a locking member penetrating the support frame (251) and being locked in a corresponding connecting hole (2596).

11. A housing (20), comprising:
a first frame body (21);
a second frame body (23); and
the rotating device (25) according to any one of claims 1 to 10,
wherein the rotating device (25) is connected between the first frame body (21) and the second frame body (23), and the rotating device (25) is configured to fold or unfold the first frame body (21) and the second frame body (23).

12. The housing (20) according to claim 11, wherein a first accommodating groove (211) is defined on a side of the first frame body (21) adjacent to the second frame body (23), a second accommodating groove (231) is defined on a side of the second frame body (23) adjacent to the first frame body (21), the first accommodating groove (211) and the second accommodating groove (231) define an accommodating space, and the rotating device (25) is accommodated in the accommodating space;
wherein a first mounting groove is defined in the first frame body (21), a second mounting groove is defined in the second frame body (23), the rotating racks (253) of the pair of rotation combinations (250) of the rotating device (25) are connected into the first mounting groove of the first frame body (21) and the second mounting groove of the second frame body (23), respectively; and
wherein the housing (20) further comprises two cover plates (60) respectively covering the first frame body (21) and the second frame body (23), and in an unfolded state of the first frame body (21) and the second frame body (23), front surfaces of the two cover plates (60) are on a same plane.

13. An electronic device (100), comprising:
a flexible screen (30); and
the housing (20) according to claim 11 or 12,
wherein the flexible screen (30) is arranged on the housing (20).

14. The electronic device (100) according to claim 13, wherein a rotation shaft of the pair of rotation combinations (250) of the rotating device (25) is a virtual shaft, and an axis of the virtual shaft is located on a neutral layer of the flexible screen (30).

## Patentansprüche

1. Drehvorrichtung (25), umfassend:
ein Paar Drehkombinationen (250); und
eine Getriebekombination (256), die sich zwischen dem Paar Drehkombinationen (250) befindet,
wobei jede Drehkombination (250) des Paars Drehkombinationen (250) einen Stützrahmen (251), einen drehbar mit dem Stützrahmen (251) verbundenen Drehträger (253) und eine zwischen dem Stützrahmen (251) und dem Drehträger (253) angeordnete Verbindungsstange (254) umfasst; wobei ein Ende der Verbindungsstange (254) beweglich mit dem Drehträger (253) verbunden ist und das andere Ende der Verbindungsstange (254) mit einem Antriebsrad (2540) ausgestattet ist, das dazu ausgelegt ist, in die Getriebekombination (256) einzugreifen, und drehbar mit dem Stützrahmen (251) verbunden ist;
wobei der Drehträger (253) dazu ausgelegt ist, sich relativ zu einem korrespondierenden Stützrahmen (251) zu drehen und eine korrespondierende Verbindungsstange (254) anzutreiben, sodass sie sich dreht; wobei die Verbindungsstange (254) dazu ausgelegt ist, sich zu drehen und das Antriebsrad (2540) anzutreiben, sodass es sich dreht; wobei das Antriebsrad (2540) dazu ausgelegt ist, sich zu drehen und die Getriebekombination (256) anzutreiben, sodass sie sich dreht; und wobei die Drehträger (253) des Paars Drehkombinationen (250) synchron drehbar sind;
wobei der Drehträger (253) einen Montagerahmen (257) umfasst,
**dadurch gekennzeichnet, dass**
der Drehträger (253) ferner einen auf dem Montagerahmen (257) angeordneten Drehblock (255) umfasst, der Drehblock (255) und die Verbindungsstange (254) sich auf einer selben Seite des Montagerahmens (257) befinden, eine Aufnahmeöffnung (2516) in dem Stützrahmen (251) definiert ist und der Drehblock (255) drehbar in der Aufnahmeöffnung (2516) verbunden ist.

2. Drehvorrichtung (25) nach Anspruch 1, wobei ein von dem Antriebsrad (2540) abgewandtes Ende der Verbindungsstange (254) durch eine Anschlussverbindung zwischen einer Verbindungswelle (2542) und einem Verbindungsstangenschlitz (2576) mit dem Drehträger (253) verbunden ist und die Verbindungswelle (2542) verschiebbar und drehbar in dem Verbindungsstangenschlitz (2576) verbunden ist.

3. Drehvorrichtung (25) nach Anspruch 2, wobei der Verbindungsstangenschlitz (2576) ein schräger Schlitz ist, der Verbindungsstangenschlitz (2576) in dem Drehträger (253) definiert ist und die Verbindungswelle (2542) auf der Verbindungsstange (254) angeordnet ist.

4. Drehvorrichtung (25) nach Anspruch 3, wobei zwei Verlängerungsplatten (2573) gegenüberliegend voneinander beabstandet und auf dem Montagerahmen (257) bereitgestellt sind;
wobei jede der zwei Verlängerungsplatten (2573) den Verbindungsstangenschlitz (2576), der darin definiert ist, um ein Paar Verbindungsstangenschlitze (2576) zu bilden, aufweist und die Verbindungswelle (2542) an dem von dem Antriebsrad (2540) abgewandten Ende der Verbindungsstange (254) befestigt ist; und
wobei das Ende der Verbindungsstange (254), an dem die Verbindungswelle (2542) befestigt ist, sich zwischen den zwei Verlängerungsplatten (2573) befindet und zwei gegenüberliegende Enden der Verbindungswelle (2542) in korrespondierender Weise beweglich in das Paar Verbindungsstangenschlitze (2576) eingeführt sind.

5. Drehvorrichtung (25) nach Anspruch 1, wobei eine Drehwelle zwischen dem Drehblock (255) und dem Stützrahmen (251) eine virtuelle Welle ist.

6. Drehvorrichtung (25) nach Anspruch 1, wobei der Drehblock (255) und der Stützrahmen (251) durch eine Drehrippe (2518) und eine bogenförmige Nut (2552) miteinander verbunden sind, die Drehrippe (2518) verschiebbar in der bogenförmigen Nut (2552) aufgenommen wird und eine Achse der bogenförmigen Nut (2552) mit einer Achse der Drehwelle zwischen dem Drehblock (255) und dem Stützrahmen (251) zusammenfällt.

7. Drehvorrichtung (25) nach Anspruch 6, wobei jede von zwei gegenüberliegenden Seitenflächen des Drehblocks (255) die bogenförmige Nut (2552), die darin definiert ist, um ein Paar bogenförmiger Nuten (2552) zu bilden, aufweist und jede von zwei gegenüberliegenden Innenwänden der Aufnahmeöffnung (2516) des Stützrahmens (251) die Drehrippe (2518), die darauf bereitgestellt ist, um ein Paar Drehrippen (2518) in Korrespondenz mit dem Paar bogenförmiger Nuten (2552) zu bilden, aufweist; oder wobei jede von zwei gegenüberliegenden Innenwänden der Aufnahmeöffnung (2516) des Stützrahmens (251) die bogenförmige Nut (2552), die darin definiert ist, um ein Paar bogenförmiger Nuten (2552) zu bilden, aufweist und jede von zwei gegenüberliegenden Seitenflächen des Drehblocks (255) die Drehrippe (2518), die darauf bereitgestellt ist, um ein Paar Drehrippen (2518) in Korrespondenz mit dem Paar bogenförmiger Nuten (2552) zu bilden, aufweist.

8. Drehvorrichtung (25) nach Anspruch 1, wobei der Drehträger (253) ferner eine zwischen dem Drehblock (255) und dem Montagerahmen (257) verbundene Verbindungsplatte (258) umfasst, der Stützrahmen (251) eine in der Aufnahmeöffnung (2516) und auf einer Seite der Aufnahmeöffnung (2516) angeordnete Positionierstange (2512) umfasst und die Positionierstange (2512) dazu ausgelegt ist, eine Rückfläche der Verbindungsplatte (258) zu stützen; und
wobei eine Verstärkungsplatte auf der Verbindungsplatte (258) bereitgestellt ist, um eine Verbindung zwischen dem Drehblock (255) und dem Montagerahmen (257) zu verstärken.

9. Drehvorrichtung (25) nach Anspruch 1, wobei die Getriebekombination (256) ein Paar Getriebezahnräder (2560), die ineinander eingreifen, umfasst,
das Paar Getriebezahnräder (2560) drehbar zwischen zwei Stützrahmen (251) angeordnet ist und das Paar Getriebezahnräder (2560) in korrespondierender Weise in die Antriebsräder (2540) der Verbindungsstangen (254) des Paars Drehkombinationen (250) eingreift.

10. Drehvorrichtung (25) nach Anspruch 1, ferner umfassend ein Gehäuse (20), wobei ein Paar Verbindungsblöcke (2595) auf einer Innenfläche des Gehäuses (20) bereitgestellt ist, eine Verbindungsöffnung (2513) auf einer Rückfläche jedes Stützrahmens (251) eines Paars Stützrahmen (251) definiert ist und das Paar Verbindungsblöcke (2595) jeweils mit den Verbindungsöffnungen (2513) des Paars Stützrahmen (251) verbunden ist; und
wobei ein Verbindungsloch (2596) in jedem Verbindungsblock (2595) des Paars Verbindungsblöcke (2595) definiert ist und das Paar Drehkombinationen (250) durch ein einrastendes Bauteil, das den Stützrahmen (251) durchdringt und in einem korrespondierenden Verbindungsloch (2596) eingerastet ist, in dem Gehäuse (20) befestigt ist.

11. Gehäuse (20), umfassend:
einen ersten Rahmenkörper (21);
einen zweiten Rahmenkörper (23); und
die Drehvorrichtung (25) nach einem der Ansprüche 1 bis 10,
wobei die Drehvorrichtung (25) zwischen dem ersten Rahmenkörper (21) und dem zweiten Rahmenkörper (23) verbunden ist und die Drehvorrichtung (25) dazu ausgelegt ist, den ersten Rahmenkörper (21) und den zweiten Rahmenkörper (23) zusammen- oder auseinanderzuklappen.

12. Gehäuse (20) nach Anspruch 11, wobei eine erste Aufnahmenut (211) auf einer Seite des ersten Rahmenkörpers (21) neben dem zweiten Rahmenkörper (23) definiert ist, eine zweite Aufnahmenut (231) auf einer Seite des zweiten Rahmenkörpers (23) neben dem ersten Rahmenkörper (21) definiert ist, die erste Aufnahmenut (211) und die zweite Aufnahmenut (231) einen Aufnahmeraum definieren und die Drehvorrichtung (25) in dem Aufnahmeraum aufgenommen wird;
wobei in dem ersten Rahmenkörper (21) eine erste Montagenut definiert ist, in dem zweiten Rahmenkörper (23) eine zweite Montagenut definiert ist, die Drehträger (253) des Paars Drehkombinationen (250) der Drehvorrichtung (25) in der ersten Montagenut des ersten Rahmenkörpers (21) bzw. der zweiten Montagenut des zweiten Rahmenkörpers (23) verbunden sind; und
wobei das Gehäuse (20) ferner zwei Abdeckplatten (60), die den ersten Rahmenkörper (21) bzw. den zweiten Rahmenkörper (23) abdecken, umfasst und die Vorderflächen der zwei Abdeckplatten (60) in einem auseinandergeklappten Zustand des ersten Rahmenkörpers (21) und des zweiten Rahmenkörpers (23) auf einer selben Ebene sind.

13. Elektronisches Gerät (100), umfassend:
einen biegsamen Bildschirm (30); und
das Gehäuse (20) nach Anspruch 11 oder 12,
wobei der biegsame Bildschirm (30) auf dem Gehäuse (20) angeordnet ist.

14. Elektronisches Gerät (100) nach Anspruch 13, wobei eine Drehwelle des Paars Drehkombinationen (250) der Drehvorrichtung (25) eine virtuelle Welle ist und eine Achse der virtuellen Welle sich auf einer neutralen Schicht des biegsamen Bildschirms (30) befindet.

## Revendications

1. Dispositif rotatif (25), comprenant :
une paire de combinaisons de rotation (250); et
une combinaison d'engrenage (256) située entre la paire de combinaisons de rotation (250),
dans lequel chaque combinaison de rotation (250) de la paire de combinaisons de rotation (250) comprend une structure de support (251), une crémaillère rotative (253) reliée en rotation à la structure de support (251), et une tige de liaison (254) disposée entre la structure de support (251) et la crémaillère rotative (253) ; une extrémité de la tige de liaison (254) est reliée de façon mobile à la crémaillère rotative (253), et l'autre extrémité de la tige de liaison (254) est munie d'un engrenage d'entraînement (2540) conçu pour venir en prise avec la combinaison d'engrenage (256) et est reliée en rotation à la structure de support (251) ;
dans lequel la crémaillère rotative (253) est conçue pour tourner par rapport à une structure de support correspondante (251) et entraîner une tige de liaison correspondante (254) en rotation ; la tige de liaison (254) est conçue pour tourner et entraîner l'engrenage d'entraînement (2540) en rotation ; l'engrenage d'entraînement (2540) est conçu pour tourner et entraîner la combinaison d'engrenage (256) en rotation ; et les crémaillères rotatives (253) de la paire de combinaisons de rotation (250) peuvent tourner de façon synchrone ;
dans lequel la crémaillère rotative (253) comprend une structure de montage (257),
**caractérisé en ce que**
la crémaillère rotative (253) comprend en outre un bloc rotatif (255) disposé sur la structure de montage (257), le bloc rotatif (255) et la tige de liaison (254) sont situés sur un même côté de la structure de montage (257), une ouverture de logement (2516) est définie dans la structure de support (251), et le bloc rotatif (255) est relié en rotation dans l'ouverture de logement (2516).

2. Dispositif rotatif (25) selon la revendication 1, dans lequel une extrémité de la tige de liaison (254) faisant face à l'opposé de l'engrenage d'entraînement (2540) est reliée à la crémaillère rotative (253) par l'intermédiaire d'un raccord de fixation entre un arbre de liaison (2542) et une fente de tige de liaison (2576), et l'arbre de liaison (2542) est relié de façon coulissante et rotative dans la fente de tige de liaison (2576).

3. Dispositif rotatif (25) selon la revendication 2, dans lequel la fente de tige de liaison (2576) est une fente inclinée, la fente de tige de liaison (2576) est définie dans la crémaillère rotative (253), et l'arbre de liaison (2542) est disposé sur la tige de liaison (254).

4. Dispositif rotatif (25) selon la revendication 3, dans lequel deux plaques d'extension (2573) sont espacées l'une de l'autre de manière opposée et sont placées sur la structure de montage (257) ;
chacune des deux plaques d'extension (2573) comporte la fente de tige de liaison (2576) définie en son sein pour former une paire de fentes de tige de liaison (2576), et l'arbre de liaison (2542) est fixé sur l'extrémité de la tige de liaison (254) faisant face à l'opposé de l'engrenage d'entraînement (2540) ; et
l'extrémité de la tige de liaison (254) sur laquelle est fixé l'arbre de liaison (2542) est située entre les deux plaques d'extension (2573), et deux extrémités opposées de l'arbre de liaison (2542) sont insérées de façon mobile dans la paire de fentes de tige de liaison (2576), de façon correspondante.

5. Dispositif rotatif (25) selon la revendication 1, dans lequel un arbre rotatif entre le bloc rotatif (255) et la structure de support (251) est un arbre virtuel.

6. Dispositif rotatif (25) selon la revendication 1, dans lequel le bloc rotatif (255) et la structure de support (251) sont reliés l'un à l'autre par l'intermédiaire d'une nervure rotative (2518) et d'une rainure en forme d'arc (2552), la nervure rotative (2518) est logée de façon coulissante dans la rainure en forme d'arc (2552), et un axe de la rainure en forme d'arc (2552) coïncide avec un axe de l'arbre rotatif entre le bloc rotatif (255) et la structure de support (251).

7. Dispositif rotatif (25) selon la revendication 6, dans lequel chacune de deux surfaces opposées du bloc rotatif (255) comporte la rainure en forme d'arc (2552) définie en son sein pour former une paire de rainures en forme d'arc (2552), et chacune de deux parois internes opposées de l'ouverture de logement (2516) de la structure de support (251) comporte la nervure rotative (2518) placée sur elle pour former une paire de nervures rotatives (2518) en correspondance avec la paire de rainures en forme d'arc (2552) ; ou
dans lequel chacune de deux parois internes opposées de l'ouverture de logement (2516) de la structure de support (251) comporte la rainure en forme d'arc (2552) définie en son sein pour former une paire de rainures en forme d'arc (2552), et chacune de deux surfaces latérales opposées du bloc rotatif (255) comporte la nervure rotative (2518) placée sur elle pour former une paire de nervures rotatives (2518) en correspondance avec la paire de rainures en forme d'arc (2552).

8. Dispositif rotatif (25) selon la revendication 1, dans lequel la crémaillère rotative (253) comprend en outre une plaque de liaison (258) reliée entre le bloc rotatif (255) et la structure de montage (257), la structure de support (251) comprend une tige de positionnement (2512) disposée dans l'ouverture de logement (2516) et sur un côté de l'ouverture de logement (2516), et la tige de positionnement (2512) est conçue pour supporter une surface arrière de la plaque de liaison (258) ; et
dans lequel une plaque de renfort est placée sur la plaque de liaison (258) pour renforcer une liaison entre le bloc rotatif (255) et la structure de montage (257).

9. Dispositif rotatif (25) selon la revendication 1, dans lequel la combinaison d'engrenage (256) comprend une paire d'engrenages de transmission (2560) en prise l'un avec l'autre,
la paire d'engrenages de transmission (2560) est disposée en rotation entre deux structures de support (251), et la paire d'engrenages de transmission (2560) vient en prise avec les engrenages d'entraînement (2540) des tiges de liaison (254) de la paire de combinaisons de rotation (250), de façon correspondante.

10. Dispositif rotatif (25) selon la revendication 1, comprenant en outre un boîtier (20),
dans lequel une paire de blocs de liaison (2595) est placée sur une surface interne du boîtier (20), une ouverture de liaison (2513) est définie sur une surface arrière de chaque structure de support (251) d'une paire de structures de support (251), et la paire de blocs de liaison (2595) est reliée aux ouvertures de liaison (2513) de la paire de structures de support (251), respectivement ; et
dans lequel un trou de liaison (2596) est défini dans chaque bloc de liaison (2595) de la paire de blocs de liaison (2595), et la paire de combinaisons de rotation (250) est fixée dans le boîtier (20) par un organe de verrouillage pénétrant dans la structure de support (251) et verrouillé dans un trou de liaison correspondant (2596).

11. Boîtier (20), comprenant :
un premier corps de structure (21) ;
un second corps de structure (23) ; et
le dispositif rotatif (25) selon l'une quelconque des revendications 1 à 10,
dans lequel le dispositif rotatif (25) est relié entre le premier corps de structure (21) et le second corps de structure (23), et le dispositif rotatif (25) est conçu pour plier ou déplier le premier corps de structure (21) et le second corps de structure (23).

12. Boîtier (20) selon la revendication 11, dans lequel une première rainure de logement (211) est définie sur un côté du premier corps de structure (21) adjacent au second corps de structure (23), une seconde rainure de logement (231) est définie sur un côté du second corps de structure (23) adjacent au premier corps de structure (21), la première rainure de logement (211) et la seconde rainure de logement (231) définissent un espace de logement, et le dispositif rotatif (25) est logé dans l'espace de logement ;
dans lequel une première rainure de montage est définie dans le premier corps de structure (21), une seconde rainure de montage est définie dans le second corps de structure (23), les crémaillères rotatives (253) de la paire de combinaisons de rotation (250) du dispositif rotatif (25) sont reliées dans la première rainure de montage du premier corps de structure (21) et la seconde rainure de montage du second corps de structure (23), respectivement ; et
le boîtier (20) comprenant en outre deux plaques de couverture (60) couvrant respectivement le premier corps de structure (21) et le second corps de structure (23), et dans un état déplié du premier corps de structure (21) et du second corps de structure (23), des surfaces avant des deux plaques de couverture (60) se trouvant sur un même plan.

13. Dispositif électronique (100), comprenant :
un écran flexible (30) ; et
le boîtier (20) selon la revendication 11 ou 12,
dans lequel l'écran flexible (30) est disposé sur le boîtier (20).

14. Dispositif électronique (100) selon la revendication 13, dans lequel un arbre rotatif de la paire de combinaisons de rotation (250) du dispositif rotatif (25) est un arbre virtuel, et un axe de l'arbre virtuel est situé sur une couche neutre de l'écran flexible (30).
